(19) Europäisches Patentamt
European Patent Office
Office européen des brevets

(11) Publication number: **0 056 904**
**B1**

(12) # EUROPEAN PATENT SPECIFICATION

(45) Date of publication of patent specification: **21.08.85**

(21) Application number: **81305986.2**

(22) Date of filing: **21.12.81**

(51) Int. Cl.$^4$: **H 01 L 29/06,** H 01 L 29/36, H 01 L 27/08

(54) **High electron mobility single heterojunction semiconductor devices and methods of production of such devices.**

(30) Priority: **29.12.80 JP 187342/80**
**29.12.80 JP 187343/80**

(43) Date of publication of application:
**04.08.82 Bulletin 82/31**

(45) Publication of the grant of the patent:
**21.08.85 Bulletin 85/34**

(84) Designated Contracting States:
**DE FR GB NL**

(56) References cited:

**ELECTRONICS LETTERS, Vol. 16, no. 17, August 1980, Hitchin D. DELAGEBEAUDEUF et al. "Two-Dimensional Electron Gas M.E.S.F.E.T. Structure", pages 667 to 668**

(73) Proprietor: **FUJITSU LIMITED**
**1015, Kamikodanaka Nakahara-ku**
**Kawasaki-shi Kanagawa 211 (JP)**

(72) Inventor: **Nishi, Hidetoshi**
**1-22-10, Chuorinkan Yamato-shi**
**Kanagawa 242 (JP)**
Inventor: **Hiyamizu, Satoshi**
**1-21-15, Izumihonmachi Komae-shi**
**Tokyo 201 (JP)**
Inventor: **Okamura, Shigeru**
**3486, Honmachida, Machida-shi**
**Tokyo 194 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 056 904 B1

**Description**

This invention relates to high electron mobility semiconductor devices, and methods of production of such devices.

The present invention is concerned with semiconductor devices which utilise electrons accumulated in the neighbourhood of a single heterojunction as a result of a difference between the electron affinities of the two different kinds of semiconductor between which the single heterojunction is formed.

More specifically, the present invention relates to integrated circuits provided with an active semiconductor device or an FET of which the conduction medium is a group of free electrons which are accumulated in the neighbourhood of a single heterojunction, between a pair of layers, of respective different kinds of semiconductor, which have electron affinities different from one another, as a result of the difference in electron affinities of the semiconductors.

Silicon (Si) has been the material most widely used for production of integrated circuits provided with FET's. Albeit that the switching speeds of FET's can be improved by decreasing the geometrical dimensions of the FET's, particularly by decreasing the distance between the source and drain of an FET, there is an inherent limitation of the degree of improvement which can be achieved, which limitation concerns the mobility of the electrons or holes in silicon. In order to overcome this limitation, various attempts have been made to utilise compound semiconductors. One of the attempts involves the utilisation of a group of free electrons accumulated in the neighbourhood of a single heterojunction between a pair of layers, of different kinds of semiconductor, having different electron affinities, due to a difference in electron affinities of the semiconductors. Such a group of free electrons (hereinafter referred to as a quadratic electron gas, a quasi-two-dimensional electron gas) exists in a region of an extremely small thickness, of for example several tens of Angstroms, and it suffers the effects of ionised impurity scattering to a lesser extent, thereby providing a considerable increase in electron mobility, particularly at cryogenic temperatures, at which the effects of ionised impurity scattering are the dominant factor limiting electron mobility.

This idea was reduced to practice by an invention concerning a high electron mobility single heterojunction active semiconductor device or a high electron mobility transistor.

A high electron mobility transistor is provided with a single heterojunction between a pair of layers of different semiconductors. The different semiconductors are selected so that there is a substantial difference between their electron affinities. For example, GaAs and AlGaAs layers may be used. Further, the electron layer of lower electron affinity is preferably doped with an n-type impurity. As a result of the difference in electron affinities, the semiconductor layer of the lower electron affinity is depleted of some quantity of electrons which move to the semiconductor layer having the higher electron affinity. As described earlier, the electrons accumulate in an extremely thin region close to the single heterojunction. These accumulated electrons, or the quasi-two-dimensional electron gas, provide a channel. The semiconductor layer having the lower electron affinity and the semiconductor layer having the higher electron affinity will be referred to respectively as an electron source layer and a channel layer. The electrons accumulated along the single heterojunction do not spread beyond the spread of electron wave (the electrons do not spread beyond a region of a thickness determined by the wave length of an electron wave function). In other words, the entire quantity of electrons is confined to an extremely thin region, of a thickness of only several tens of Angstroms. This means that the electrons suffer the effects of ionised-impurity scattering to a lesser extent. Therefore, the mobility of the electrons, or of the quadratic or two-dimensional electron gas is greatly improved, particularly at cryogenic temperatures at which the effects of ionised-impurity scattering are increased.

On the other hand, the electron source layer is depleted to some extent. Therefore, if the thickness of the electron source layer is properly selected it is possible to make the electron source layer entirely isolated from a substrate. In such a case, the electrons accumulated along the single heterojunction, or the two-dimensional electron gas, function or functions as the only channel for the layer configuration consisting of an electron source layer and a channel layer. Accordingly, when one or more insulated gates, or Schottky barrier gates, together with a source and drain pair are placed on the top surface of such a layer configuration an FET can be provided whose conduction channel is limited to the channel formed by the electrons accumulated along the single heterojunction, that is, the quadratic electron gas.

It will be noted that the thickness of an electron source layer may be required to be less than a specific thickness which is determined predominantly by the kinds of semiconductors employed and the temperature at which the device is used.

Two different layer configurations are available for such a high electron mobility transistor. In one configuration a channel layer is grown on a substrate before an electron source layer is grown on the channel layer and before one or more gates, and a source and drain pair, are grown on the layer configuration. In the other configuration an electron source layer is grown on a substrate before a channel layer is grown on the electron source layer and one or more gates, and a source and drain pair, placed on the layer configuration.

The former layer configuration allows a high electron mobility transistor to function either in a normally-on mode (depletion mode) or in a normally-off mode (enhancement mode),

depending upon whether or not the thickness of an electron source layer is larger than a specific thickness, which is determined predominantly by the kinds of semiconductors employed and the temperature at which the device is used.

The latter layer configuration allows a high electron mobility transistor to function either in a normally-on mode (depletion mode) or in a normally-off mode (enhancement mode) depending upon whether or not the ratio of the thickness of the channel layer and the thickness of an electron source layer is larger than a specific value, which is determined predominantly by the kinds of semiconductors employed and the temperature at which the device is used.

As alternatives to the use of GaAs and AlGaAs for layers of different electron affinities, layers of Ge and AlGaAs, or of Ge and GaAs, or of InSb and CdTe, or of InAs and GaSb, et al, can be used.

A gate or gates can be fabricated either as Schottky barrier gate types or insulated gate types.

In a case in which layers of GaAs and AlGaAs are used, electron mobilities have been determined to be $1.5\times10^5 cm^2/VSec$ and $5\times10^5 cm^2/VSec$ respectively at 77°K and 5°K.

As described above, a high electron mobility transistor can exhibit an excellent electron mobility, thereby providing excellent high frequency performance and a high switching speed particularly at cryogenic temperatures.

However, some problems still remain particularly in relation to the realistic production of an integrated circuit using high electron mobility transistors.

The major problems remaining are:—

(1) Isolation of respective high electron mobility transistors contained in an integrated circuit,

(2) Mutual connection of high electron mobility transistors contained in an integrated circuit, and

(3) Production of an integrated circuit provided with a plurality of high electron mobility transistors which have different characteristics.

Previously, the foregoing problems have been partly met by the application of one or more etching processes to selected areas, for the adjustment or revision of layer configuration for the ultimate purpose of regulating the electron sheet concentration of the two-dimensional electron gas. There are, however, various drawbacks to such a procedure:— 1. Difficulty in making the integrated circuit in a planar configuration. 2. Difficulty in precise control of electron sheet concentration of the two-dimensional electron gas. 3. The complicated nature of the etching process involved. 4. Cost disadvantages incurred because of the etching processes, and so on.

In the article "Two-Dimensional Electron Gas M.E.S.F.E.T. Structures" Electronics Letters, Vol. 16 No. 17, Aug. 1980, pp. 667—668, is disclosed a structure with an Si-doped AlgaAs layer and an Sn-doped GaAs layer. It is stated that the existence of a two-dimensional electron gas at the AlGaAs—GaAs heterojunction depends on the doping of the AlGaAs layer.

According to the present invention there is provided a method of manufacturing a high electron mobility semiconductor device having first and second layers of semiconductors having lesser and greater electron affinities respectively, to provide a heterojunction in the device, wherein impurity concentration and/or impurity type is selected surface regions of the first layer is selectively controlled, thereby to regulate the sheet concentration of electrons accumulated in proximity to the heterojunction in consequence of the different electron affinities of the first and second layers.

Embodiments of this invention can provide an integrated circuit having one or more high electron mobility transistors therein which are isolated from one another, and a method of production thereof.

Embodiments of this invention can provide an integrated circuit having a plurality of high electron mobility transistors therein, each of which has different characteristics.

An integrated circuit embodying this invention can be provided with high electron mobility transistors which are separated from one another by an isolation area in which the occurrence of a two-dimensional electron gas is inhibited. Such an isolation area is produced for example by introduction into a limited area, a selected surface region, corresponding to the isolation area, of a p-type impurity to compensate an n-type impurity contained in an electron source layer, as a result reducing the quantity of free electrons contained in that limited area of the electron source layer. This decrease in the quantity of free electrons contained in the electron source layer is effective to exclude the two-dimensional electron gas from the corresponding limited area, thereby providing an isolation area, whilst leaving the two-dimensional electron gas in other areas in which the high electron mobility transistors are produced. Ion implantation processes, diffusion processes, or molecular beam epitaxy processes accompanied by ion beam doping may be employed for the foregoing introduction of a p-type impurity to compensate for n-type impurity contained in the electron source layer.

An integrated circuit embodying this invention can be provided with high electron mobility transistors which are connected with one another by means of the two-dimensional electron gas. The two-dimensional, or quadratic, electron gas which acts as a conduction channel to connect high electron mobility transistors is produced, for example, by introduction of an n-type impurity into a selected surface region corresponding to a limited area of an electron source layer which originally contains a small amount of n-type impurities, which limited area then corresponds to the above-mentioned conduction channel. Due to the increase in the quantity of free electrons contained in the said limited area of the electron source layer, the two-dimensional electron gas

occurs exclusively in the area corresponding to the conduction channel for connecting high electron mobility transistors produced in one integrated circuit. Ion beam implantation processes, diffusion processes or molecular beam epitaxy processes accompanied by ion beam doping may be employed for the foregoing introduction of an n-type impurity into a selected surface region of an electron source layer.

An integrated circuit embodying this invention can be provided with a plurality of high electron mobility transistors some of which have a layer configuration allowing a two-dimensional electron gas to occur (to a greater or lesser extent) and the others of which have a layer configuration which inhibits the occurrence of a two-dimensional electron gas (to a greater or lesser extent). The former layer configuration can be provided with a variety of two-dimensional electron gas sheet electron concentrations, or a variety of pinch-off voltages, on the assumption that a depletion mode FET is produced therefrom. The latter layer configuration can be provided with a variety of amounts of electrons contained in an electron source layer, or a variety of pinch-off voltages, on the assumption that an enhancement mode FET is produced therefrom. The former layer configuration is produced either by introduction of, for example, a n-type impurity into a selected surface region corresponding to a limited area of an electron source layer which originally does not contain a sufficient amount of n-type impurities to allow a two-dimensional electron gas to occur, or by initially growing an electron source layer which contains a sufficient amount of n-type impurities to allow a two-dimensional electron gas to occur. The latter layer configuration is produced either by introduction of, for example, a p-type impurity into a selected surface region corresponding to a limited area of an electron source layer which originally contains a sufficient amount of n-type impurities to allow a two-dimensional electron gas to occur, or by initially growing an electron source layer which does not contain a sufficient amount of n-type impurities to allow a two-dimensional electron gas to occur. Ion implantation processes diffusion processes or molecular beam epitaxy accompanied by ion beam doping may be employed for the foregoing introduction of n-type or p-type impurities into selected surface regions of an electron source layer.

The aforementioned processes for introduction of impurities into a selected surface region of an electron source layer are effective for adjusting or altering the pinch-off voltage(s) of one or more of the high electron mobility transistors contained in an integrated circuit.

Each of the foregoing embodiments, mentioned by way of example, can be modified to provide a case in which an original layer configuration is produced which allows an electron source layer to contain a medium amount of n-type impurities, followed by introduction of n-type or p-type impurities respectively to specific surface regions of the source layer, to increase the amount of n-type impurity or the amount of p-type impurity in the corresponding specific areas, as a result allowing a two-dimensional electron gas to occur in desired areas.

The present invention makes use of the fact that the electron sheet concentration of a two-dimensional electron gas can be regulated by means of the concentration of n-type impurities contained in an electron source layer, which can in turn be regulated by introduction of n-type impurity or p-type impurity (into the electron source layer) which can be effected by diffusion performed at a relatively low temperature, molecular beam epitaxy accompanied by ion doping or ion implantation followed by heat treatment applied to the semiconductor layers at a low temperature which has no adverse effect on the crystal condition of the semiconductor layer. It will be noted that since introduced impurities are not required to reach the heterojunction, the introduction of ions into the electron source layer does not involve any of the adverse effects caused by ionised-impurity scattering.

Embodiments of the present invention can provide integrated circuits with active semiconductor devices or FET's the conduction medium of which is a group of free electrons accumulated in the neighbourhood of a single heterojunction between layers of semiconductors of different electron affinities. One or more selected surface regions of the semiconductor layer which has a higher electron affinity than the other semiconductor layer contains or contain a quantity of impurities for adjusting the sheet concentration of the foregoing group of free electrons after completion of the foregoing semiconductor layer configuration, thereby to allow production of (1) integrated circuits provided with active semiconductor devices or FET's of which the conduction medium is a group of free electrons and which are isolated from one another by a semiconductor layer configuration which prevents occurrence of the group of free electrons, (2) integrated circuits provided with active semiconductor devices or FET's which are connected with one another by means of the group of free electrons and (3) integrated circuits provided with a plurality of active semiconductor devices or FET's each of which has different characteristics. Embodiments of this invention provide methods for production of each of the foregoing kinds of integrated circuits.

Reference is made, by way of example, to the accompanying drawings, in which:—

Figure 1 is a graph illustrating the hole concentration profile of an AlGaAs layer after Zn ions have been implanted therein,

Figure 2 is a cross-sectional view illustrating an AlGaAs and GaAs layer configuration of test pieces into which various amounts of Zn were implanted for the production of high electron mobility transistors having various pinch-off voltages,

Figure 3 is a graph illustrating the relationship between pinch-off voltage and implanted Zn concentration,

Figure 4 is a cross-sectional view of a test piece in which mutual isolation of elements formed therein is provided in accordance with an embodiment of the present invention.

Figure 5 is a cross-sectional view of a test piece in which the interconnection of elements formed therein is provided in accordance with an embodiment of the present invention,

Figure 6 is a cross-sectional view of a wafer to be used in the production of an E/D mode integrated circuit in accordance with an embodiment of this invention, at a stage in the production after completion of Gaas and AlGaAs layers,

Figure 7 is a cross-sectional view of the wafer of Figure 6 after completion of a process step for introduction of n-type impurities into limited areas of an electron source layer thereof,

Figure 8 is a cross-sectional view of the wafer of Figure 6 after completion of a production step for the provision of sources and drains, and

Figure 9 is a cross-sectional view of the wave of Figure 6, after completion of the E/D mode integrated circuit in accordance with an embodiment of this invention.

The inventors have envisaged that introduction of impurities into an electron source layer of a layer configuration appropriate for production of a high electron mobility device or transistor is effective to regulate the electron sheet concentration of the quasi-two-dimensional electron gas which is accumulated in the neighbourhood of a single heterojunction between two semiconductor layers of the device.

To put this into effect, the following requirements are met (1) abrupt doping of impurities into the electron source layer, and (2) a high magnitude activation ratio.

The first requirement must be met, because the two-dimensional, or quadratic, electron gas must remain free of the adverse effects of ionised-impurity scattering. To meet this requirement, the projected range of the implanted impurities must be limited to approximately one third the thickness of the electron source layer.

The second requirement must be met because a limited proportion of the total quantity of implanted impurities is activated so as to be allowed to act as a donor or an acceptor.

In order to demonstrate the practicality of regulation of electron sheet concentration of a two-dimensional electron gas by means of the introduction of impurities, experiments as described below were carried out.

Representing an acceptor impurity, Zn ions were implanted into an undoped AlGaAs layer to a sheet concentration of $4.5\times10^{12}/cm^2$, employing an ion implantation energy of 50 KeV. After a film of $SiO_2$ or some other material, had been grown on the top surface of the AlGaAs layer, to prevent As from being lost at high temperature, the AlGaAs layer was annealed for approximately 20 minutes at 700°C. The resultant profile of hole concentration in the AlGaAs layer is illustrated in the graph of Figure 1 which shows a projected range Rp of implantation of 23 nm (230 Angstroms) with a deviation ΔRp of 12 nm (120 Angstroms). The activation ratio (the ratio of activated impurity sheet concentration Ns to implanted impurity concentration Nimp) was determined to be approximately 0.8. The activation energy of holes was determined to be approximately 30 MeV, which is similar to the activation energy of Si implanted in an AlGaAs layer. Similar experiments were carried out for some donor impurities, e.g. Si, and similar results were obtained. The results of these experiments demonstrate the practility of employing the above regulation mechanism.

Following this, the inventors produced high electron mobility transistors each having a different pinch-off voltage from the others starting from the same semiconductor layer configuration.

A number of test pieces as illustrated in Figure 2 were produced employing molecular beam epitaxy. As illustrated in Figure 2, a buffer layer 2 of an undoped GaAs layer was grown on a Cr doped semi-insulator GaAs substrate 1, before a channel layer 3, an undoped GaAs layer, was grown on the buffer layer 2. The channel layer 3 turns out to be n-type doped with a concentration of $10^{15}/cm^3$ due to indigenous impurities. An electron source layer 4, An AlGaAs layer, n-type doped to a concentration of $1.5\times10^{18}/cm^3$, of a thickness of approximately 80 nm (800 Angstroms), was grown on top of the channel layer 3. Si was employed as dopant. Since this layer configuration allows a two-dimensional electron gas 5 to accumulate in the neighbourhood of a heterojunction 6 indicated in Figure 2, a high electron mobility transistor produced of such a test piece functions as a normally-on mode or depletion mode transistor. The determined pinch-off voltage was −1.0 V.

Various amounts of Zn were implanted respectively into each of the test pieces. After a film of $SiO_2$ or some other equivalent material was grown on each of the test pieces, the test pieces were annealed for 20 minutes at 700°C, to activate the implanted Zn.

Thereafter, a source and drain pair (not shown) and a gate (not shown) were placed on each of the test pieces to produce high electron mobility transistors each having a pinch-off voltage different from the others. The graph of Figure 3 illustrates the determined relationship between pinch-off voltage and implanted Zn concentration. The pinch-off voltage, which is −1.0 V for an "as-grown" test piece, gradually shifts to a plus voltage with increase in the quantity of Zn implanted, to reach +0.5 V for a case in which the implanted Zn concentration is $7\times10^{12}/cm^2$, crossing the 0 V point at an implanted Zn concentration of $5\times10^{12}/cm^2$. The results of these experiments demonstrate that the pinch-off voltage of a high electron mobility transistor can be regulated by

the quantity of impurities introduced into the electron source layer.

The present invention can be employed in practice for providing embodiments of the following three kinds.

First, an integrated circuit having high electron mobility transistors which are isolated from one another, and a method of production thereof, can be provided. In other words, isolation between high electron mobility transistors produced in one integrated circuit can be provided, by means of an area in which the occurrence of a two-dimensional electron gas is inhibited.

Second, an integrated circuit having high electron mobility transistors which are connected with one another, and a method of production thereof, can be provided. In other words, connection between high electron mobility transistors produced in one integrated circuit can be provided, by means of a two-dimensional electron gas.

Third, an integrated circuit having a plurality of high electron mobility transistors of different pinch-off voltages can be provided.

With reference to Figure 4, an electron source layer 8, an n-type AlGaAs layer, is grown on a channel layer 7, an undoped GaAs layer. This layer configuration is such as to satisfy the following inequality (1), and thus a two-dimensional electron gas 9 appears along a heterojunction 10 shown in Figure 4, between the layers 7 and 8.

$$N_D > \frac{2\varepsilon_s}{qt^2}\left(V_{D1} - \frac{KT}{q}\right) \qquad (1)$$

where,

$\overline{N}_D$ is the average concentration of n-type impurities contained in the electron source layer 8,

$\varepsilon_s$ is the dielectric constant of the semiconductor of which the electron source layer is produced,

*t* is the thickness of the electron source layer 8,

*q* is the electric charge on an electron,

$V_{D1}$ is the height of a barrier which appears, under thermal equilibrium, between the electron source layer 8 and a gate (not shown) which is to be placed on the electron source layer 8,

K is Boltzmann's constant,

T is the temperature, in absolute temperature units, at which the high electron mobility transistor provided with the semiconductor layer mentioned above is to function.

The electron gas 9 is utilised for production of depletion mode high electron mobility transistors in areas designated 11 in Figure 4. Amounts of p-type impurity ions are implanted into surface regions 112 which provide isolation areas surrounding each of the high electron mobility transistors. After a film (not shown) of $SiO_2$, or of some other equivalent material, is grown on the electron source layer 8, the wafer is annealed for 20 minutes at 700°C for the purpose of activating the implanted impurity ions. The amount of acceptor impurity introduced in the isolation areas must be such that the above inequality (1) is not satisfied in those areas. This ion implantation process thus prevents the occurrence of the two-dimensional electron gas, which is the only conduction channel for this device, in the area 112, thus providing the areas 112, which surround each high electron mobility transistor, with isolation properties.

With reference to Figure 5, an electron source layer 13, an n-type or i-type AlGaAs layer, is grown on a channel layer, an undoped GaAs layer 12. This layer configuration is such as not to satisfy the above inequality (1), so that no electron gas is available in the neighbourhood of the heterojunction 14. Enhancement mode high electron mobility transistors are produced in areas designated 15. Amounts of n-type impurity ions are implanted into surface regions (areas) 16, by which high electron mobility transistors are to be connected with one another. After a film (not shown) of $SiO_2$, or of some other equivalent material is grown on the electron source layer 13, the wafer or test piece is annealed for 20 minutes at 700°C to activate the implanted impurity ions. The amount of donor impurity introduced must be sufficient to allow the above inequality (1) to be satisfied. This ion implantation process allows a quasi-two-dimensional electron gas to appear, to provide mutual connection among enhancement mode high electron mobility transistors which are produced in the areas designated 15.

It is of course possible to produce wirings on the top surface of an integrated circuit. Combination of ordinary wirings of this type and connections in accordance with an embodiment of the present invention allows a considerable degree of freedom in the provision of connections amongst component elements or high electron mobility transistors produced in an integrated circuit.

With reference to Figures 6 to 9, a process for the production of an E/D (Enhancement/Depletion) mode integrated circuit having a plurality of high electron mobility transistors each having a pinch-off voltage different from the others, in accordance with an embodiment of the present invention, will be described. Referring to Figure 6, a buffer layer 18, an undoped GaAs layer, is grown on a Cr doped semi-insulator GaAs substrate 17, before a channel layer 19, an undoped GaAs layer, is grown on the buffer layer 18. An electron source layer 20, an n-type AlGaAs layer, is grown on top of the channel layer 19. The thickness of the electron source layer and the concentration of n-type impurity therein are selected so that the inequality (1) is not satisfied. Therefore, a two dimensional electron gas is not allowed to appear along a heterojunction 21.

Referring to Figure 7, a photoresist film 22 is produced to cover the top surface of the electron source layer 20, except in areas such as 23 in which depletion mode high electron mobility transistors are to be produced. An ion implantation process is employed to introduce an n-type impurity, e.g. Si in such areas. It is important to select the ion implantation energy to limit the thickness of an n-type surface region 24 formed as a consequence of such implantation to less than the thickness of the electron source layer 20. The amount of n-type impurity implanted must be such that in areas where it is implanted the inequality (1) is satisfied. The photoresist film 22 is removed in its entirety and a film (not shown) of $SiO_2$, or some other equivalent material, is grown on top of the electron source layer 20, before the wafer is annealed for 20 minutes at 700°C to activate the implanted impurity ions. Since the quantity of electrons has been increased in areas such as 23, to satisfy inequality (1), a two-dimensioanl electron gas 25 appears exclusively in areas 24 in which depletion mode high electron mobility transistors are to be produced.

Referring to Figure 8, an Au.Ge alloy film 26 is produced on the top surface of the electron source layer 20, and then patterned to the shape of sources and drains. An annealing process is employed to form ohmic contact regions 27 which connect the sources and drains 26 and the quasi-two-dimensional electron gas 25 and the heterojunction 21 in areas 28 in which enhancement mode high electron mobility transistors are to be produced.

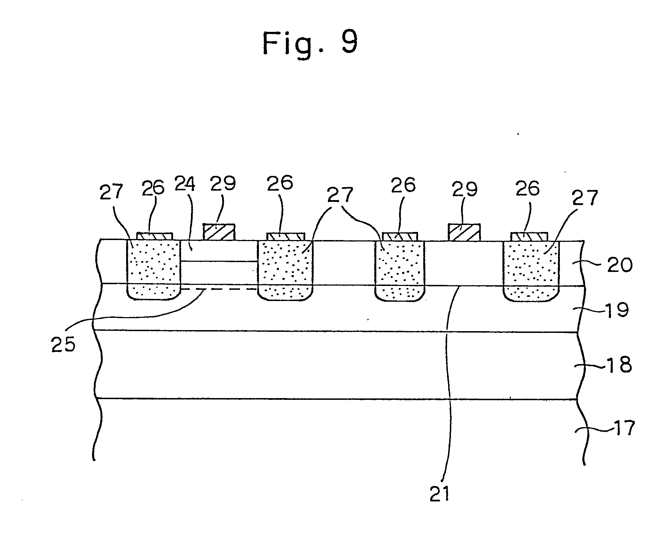

Referring to Figure 9, an evaporation process is employed for production of an Al film 29 on the top surface of the wafer, and then the Al film 29 is patterned to the shape of a gate. As a result, an E/D mode integrated circuit is provided with depletion mode high electron mobility transistors produced in areas such as area 23, and enhancement mode high electron mobility transistors produced in areas 28. In view of the usefulness of E/D mode integrated circuits, for the production of high speed logic circuits, this embodiment is of outstanding value particularly from the industrial viewpoint.

Needless to say, the foregoing three kinds of embodiment of the present invention can be combined with one another in one integrated circuit.

## Claims

1. A method of manufacturing a high electron mobility semiconductor device having first (4, 8, 13, 20) and second (3, 7, 12, 19) layers, of semiconductors having lesser and greater electron affinities respectively, to provide a heterojunction (6, 10, 14, 21) in the device, characterised in that impurity concentration and/or impurity type in selected surface regions (112, 16, 24) of the first layer (4, 8, 13, 20) is controlled, thereby to regulate the sheet concentration of electrons (5, 9, 25) accumulated in proximity to the heterojunction (6, 10, 14, 21) in consequence of the different electron affinities of the first (4, 8, 13, 20) and second (3, 7, 12, 19) layers.

2. A method as claimed in claim 1, wherein, in selected surface regions (112) of the first layer (8) impurity concentration and/or impurity type is so controlled that the accumulation of electrons (9) in proximity to regions of the heterojunction (10) corresponding to those selected surface regions (112) is inhibited, whereby, the selected surface regions (112) can provide isolation regions, for example for isolating high electron mobility transistors, formed in the device, from one another.

3. A method as claimed in claim 1, wherein, in selected surface regions (16) of the first layer (13) impurity concentration and/or impurity type is so controlled that the accumulation of electrons in proximity to regions of the heterojunction (14) corresponding to the selected surface regions (16) is encouraged, whereby the selected surface regions (16) can provide conductive pathways, for example for connecting high electron mobility transistors, formed in the device, to one another.

4. A method as claimed in claim 1, wherein, in selected surface regions (24) of the first layer (20) impurity concentration and/or impurity type is so controlled that high electron mobility transistors of the device, formed so as to employ those selected surface regions (24), have respective different pinch-off voltages.

5. A method as claimed in claim 4, wherein impurity concentration and/or impurity type is so controlled in those selected surface regions (24) that some of the high electron mobility transistors are formed as depletion mode transistors, and others are formed as enhancement mode transistors.

6. A method as claimed in any preceding claim, wherein impurity concentration and/or impurity type in the first layer (4, 8, 13, 20) is so controlled by the introduction into selected surface regions (112, 16, 24) of the first layer (4, 8, 13, 20), provided previously in an initial impurity condition, of impurities of a type or types or in an amount or amounts such as to regulate the sheet concentrations of electrons (5, 9, 25) accumulated in proximity to regions of the heterojunction (6, 10, 14, 21) corresponding to the selected surface regions (112, 16, 24).

7. A method as claimed in claim 6, wherein,

when, in an initial impurity condition, the first layer (4, 8, 13, 20) contains a sufficient amount of n-type impurities to permit accumulation of electrons (5, 9, 25) in proximity to the heterojunction (6, 10, 14, 21), p-type impurities are selectively introduced to inhibit such accumulation;

when, in an initial impurity condition, the first layer (4, 8, 13, 20) contains an insufficient amount of n-type impurities to permit accumulation of electrons (5, 9, 25) in proximity to the heterojunction (6, 10, 14, 21), n-type impurities are selectively introduced to encourage such accumulation;

when, in an initial impurity condition, the first layer (4, 8, 13, 20) contains an intermediate amount of n-type impurities, or substantially no impurities, n-type and/or p-type impurities are selectively introduced respectively to encourage

and to inhibit accumulation of electrons (5, 9, 25) in proximity to the heterojunction (6, 10, 14, 21).

8. A method as claimed in claim 6 or 7, wherein the introduction of impurities into selected surface regions (112, 16, 24) of the first layer (4, 8, 13, 20) is effected by ion implantation, a diffusion process, or molecular beam epitaxy accompanied by ion beam doping.

9. A high electron mobility semiconductor device, being an integrated circuit including a plurality of high electron mobility transistors, made by a method as claimed in any preceding claim.

**Patentansprüche**

1. Verfahren zur Herstellung einer Halbleitervorrichtung mit hoher Elektronenmobilität, mit ersten (4, 8, 13, 20) und zweiten (3, 7, 12, 19) Schichten, aus Halbleitern, welche kleinere bzw. größere Elektronenaffinitäten haben, um einen Heteroübergang (6, 10, 14, 21) in der Vorrichtung vorzusehen, dadurch gekennzeichnet, daß die Verunreinigungskonzentration und/oder der Verunreinigungstyp in ausgewählten Oberflächenbereichen (112, 16, 24) der ersten Schicht (4, 8, 13, 20) gesteuert wird, um dadurch die Schichtkonzentration von Elektronen (5, 9, 25) zu regeln, die sich infolge der unterschiedlichen Elektronenaffinitäten der ersten (4, 8, 13, 20) und der zweiten (3, 7, 12, 19) Schichten, in der Nachbarschaft des Heteroübergangs (6, 10, 14, 21) angesammelt haben.

2. Verfahren nach Anspruch 1, bei welchem in ausgewählten Oberflächenbereichen (112) der ersten Schicht (8) die Verunreinigungskonzentration und/oder Verunreinigungsart so gesteuert wird, daß die Akkumulation von Elektronen (9) in der Nachbarschaft zu Bereichen des Heteroübergangs (10), die den ausgewählte Oberflächenbereichen (112) entsprechend, unterbunden ist, wodurch die ausgewählten Oberflächenbereiche (112) isolierte Bereiche bilden können, z.B. zum Isolieren von Transistoren hoher Elektronenmobilität, welche in der Vorrichtung gebildet sind, voneinander.

3. Verfahren nach Anspruch 1, bei welchem in ausgewählten Oberflächenbereichen (16) der ersten Schicht (13) Verunreinigungskonzentration und/oder Verunreinigungsart so gesteuert werden, daß die Akkumulation von Elektronen in der Nähe der Bereiche des Heteroübergangs (14) die den ausgewählten Oberflächenbereichen (16) entsprechen, unterstützt wird, wodurch die ausgewählten Oberflächenbereiche (16) leitende Pfade bilden, z.B für die Verbindung von der Vorrichtung gebildeten Transistoren hoher Elektronenmobilität miteinander.

4. Verfahren nach Anspruch 1, bei welchem in ausgewählten Bereichen (24) der ersten Schicht (20) die Verunreinigungskonzentration und/oder die Verunreinigungsart so gesteuert wird, daß Transistoren hoher Elektronenmobilität der Vorrichtung, die so geformt sind, daß sie jene ausgewählten Oberflächenbereiche (24) verwenden, entsprechende unterschiedliche Abschnürspannungen haben.

5. Verfahren nach Anspruch 4, bei welchem der Verunreinigungskonzentration und/oder die Verunreinigungsart in jenen ausgewählten Oberflächenbereichen (24) so gesteuert werden, daß einige der Transistoren hoher Elektronenmobilität als Transistoren vom Verarmungsstyp und andere als Transistoren vom Anreicherungstyp ausgebildet sind.

6. Verfahren nach einem der vorhergehenden Ansprüche, bei welchem die Verunreinigungskonzentration und/oder die Verunreinigungsart in der ersten Schicht (4, 8, 13, 20) so gesteuert wird, indem in ausgewählte Oberflächenbereiche (112, 16, 24) der ersten Schicht (4, 8, 13, 20), die zuvor in einem anfänglichen Verunreinigungszustand vorgesehen war, Verunreinigungen von einem Typ oder von Typen oder in einer Menge oder in solchem Mengen eingeführt werden, um die Schichtkonzentrationen der Elektronen (5, 9, 25) zu regulieren, welche sich in der Nähe der Bereiche des Heteroübergangs (6, 10, 14, 21), die den ausgewählten Oberflächenbereichen (112, 16, 24) entsprechen, angesammelt haben.

7. Verfahren nach Anspruch 6, bei welchem, wenn, in einem anfänglichen Verunreinigungszustand, die erste Schicht (4, 8, 13, 20) eine ausreichende Menge von Verunreinigungen vom n-Typ enthalten, um eine Ansammlung von Elektronen (5, 9, 25) in der Nähe des Heteroübergangs (6, 10, 14, 21) zu erlauben, Verunreinigungen vom p-Typ selektiv eingeführt werden, um eine solche Akkumulation zu verhindern;

wenn, in einem anfänglichen Verunreinigungszustand, die erste Schicht (4, 8, 13, 20) eine Menge von Verunreinigungen vom n-Typ enthält, die nicht ausreicht, die Akkumulation von Elektronen (5, 9, 25) in der Nähe des Heteroübergangs (6, 10, 14, 21) zu erlauben, Verunreinigungen vom n-Typ selektiv eingeführt werden, um eine solche Akkumulation zu unterstützen;

wenn, in einem anfänglichen Verunreinigungszustand, die erste Schicht (4, 8, 13, 20) eine mittlere Menge von Verunreinigungen vom n-Typ enthält, oder im wesentlichen keine Verunreinigungen, Verunreinigungen vom n-Typ und/oder p-Typ selektiv eingeführt werden, um jeweils die Akkumulation von Elektronen (5, 9, 25) in der Nähe des Heteroübergangs (6, 10, 14, 21) zu unterstützen oder zu unterbinden.

8. Verfahren nach Anspruch 6 oder 7, bei welchem die Einführung von Verunreinigungen in ausgewählte Oberflächenbereiche (112, 16, 24) der ersten Schicht (4, 8, 13, 20) durch Ionenimplantation, einen Diffusions-prozess oder Mokeularstrahlepitaxie begleitet mit Ionenstrahldotierung bewirkt wird.

9. Halbleitervorrichtung mit hoher Elektronenmobilität, welche eine integrierte Schaltung bildet, die eine Vielzahl von Transistoren hoher Elektronenmobilität umfaßt, hergestellt durch ein Verfahren nach einem der vorhergehenden Ansprüche.

**Revendications**

1. Procédé de fabrication d'un dispositif semi-conducteur à haute mobilité des électrons comprenant une première (4, 8, 13, 20) et une seconde (3, 7, 12, 19) couches de semi-conducteurs ayant respectivement de plus petites et de plus grandes affinités électroniques, pour former une hétérojonction (6, 10, 14, 21) dans le dispositif, caractérisé en ce qu'une concentration d'impuretés et/ou un type d'impuretés dans des régions superficielles sélectionnées (112, 16, 24) de la première couche (4, 8, 13, 20) est contrôlée de manière à réguler la concentration pelliculaire des électrons (5, 9, 25) accumulés à proximité de l'hétérojonction (6, 10, 14, 21) en raison des affinités électroniques différentes de la première (4, 8, 13, 20) et la seconde (3, 7, 12, 19) couches.

2. Procédé selon la revendication 1, dans lequel, dans des régions superficielles sélectionnées (112) de la première couche (8), une concentration d'impuretés et/ou un type d'impuretés est contrôlée de manière que l'accumulation d'électrons (9) à proximité des régions de l'hétérojonction (10) correspondant à celles sélectonnées des régions superficielles (112) soit inhibée, afin que les régions superficielles sélectionnées (112) puissent constituer des régions d'isolement, par exemple pour isoler les uns des autres, des transistors à haute mobilité des électrons formés dans le dispositif.

3. Procédé selon la revendication 1, dans lequel dans des régions superficielle sélectionnées (16) de la première couche (13), une concentration d'impuretés et/ou un type d'impuretés est contrôlée de manière que l'accumulation d'électrons à proximité des régions de l'hétérojonction (14) correspondant aux régions superficielles sélectionnées (16) soit facilitée, afin que les régions superficielles sélectionnées (16) puissent constituent des circuits conducteurs, par exemple pour connecter entre eux des transistors à haute mobilité d'électrons formés dans le dispositif.

4. Procédé selon la revendication 1, dans lequel dans des régions superficielles sélectionnées (24) de la première couche (20) une concentration d'impuretés et/ou un type d'impuretés est contrôlée de manière que des transistors à haute mobilité d'électrons du dispositif, formés de manière à utiliser ces régions superficielles sélectionnées (24), possède des tensions de pincement différentes respectives.

5. Procédé selon la revendication 4, dans lequel une concentration d'impuretés et/ou type d'impuretés est contrôlée dans celles sélectionnées des régions superficielles (24) de manière que des transistors à haute mobilité des électrons soient formés comme des transistors en mode appauvri et que d'autres soient formés comme des transistors en mode enrichi.

6. Procédé selon l'une quelconque des revendications précédentes, dans lequel une concentration d'impuretés et/ou untype d'impuretés dans la première couche (4, 8, 13, 20) est contrôlée par l'introduction dans des régions superficielles sélectionnées (112, 16, 24) de la première couche (4, 8, 13, 20) prévues préalablement dans une condition initiale d'impuretés, d'impuretés d'un type ou de plusieurs types ou dans une quantité ou plusieurs quantités de manière à régler les concentrations pelliculaires d'électrons (5, 9, 25) accumulés à proximité des régions de l'hétérojonction (6, 10, 14, 21) correspondant aux régions superficielles sélectionnées (112, 16, 24).

7. Procédé selon la revendication 6, dans lequel lorsque, dans une condition initiale d'impuretés, la première couche (4, 8, 13, 20) contient une quantité suffisante d'impuretés de type N pour permettre l'accumulation d'électrons (5, 9, 25) à proximité de l'hétérojonction (6, 10, 14, 21), des impuretés de type P sont introduites sélectivement pour inhiber cette accumulation; lorsque, dans une condition initiale d'impuretés, la première couche (4, 8, 13, 20) contient une quantité insuffisante d'impuretés de type N pour permettre l'accumulation d'électrons (5, 9, 25) à proximité de l'héterojonction (6, 10, 14, 21), des impuretés de type N sont introduites sélectivement pour faciliter cette accumulation; lorsque dans une condition initiale d'impuretés, la première couche (4, 8, 13, 20) contient une quantité intermédiaire d'impuretés de type N ou pratiquement aucune impureté, des impuretés de type N et/ou de type P sont introduites sélectivement respectivement pour faciliter et pour inhiber l'accumulation d'électrons (5, 9, 25) à proximité de l'héterojonction (6, 10, 14, 21).

8. Procédé selon la revendication 6 ou 7, dans lequel l'introduction d'impuretés dans des régions superficielles sélectionnées (112, 16, 24) de la première couche (4, 8, 13, 20) est effectuée par implantation d'ions, une opération de diffusion ou une croissance épitaxiale du faisceau moléculaire accompagnée d'un dopage par faisceau ionique.

9. Dispositif semi-conducteur à haute mobilité des électrons se trouvant dans un circuit intégré, comprenant plusieurs transistors à haute mobilité des électrons, réalisé par un procédé selon l'une quelconque des revendications précédentes.

Fig. 1

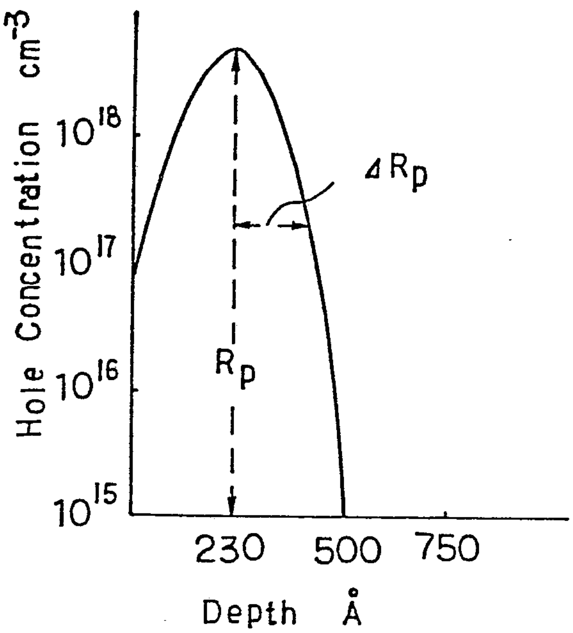
Hole Concentration cm-3
10^18
10^17
10^16
10^15
ΔRp
Rp
230
500
750
Depth Å

Fig. 2

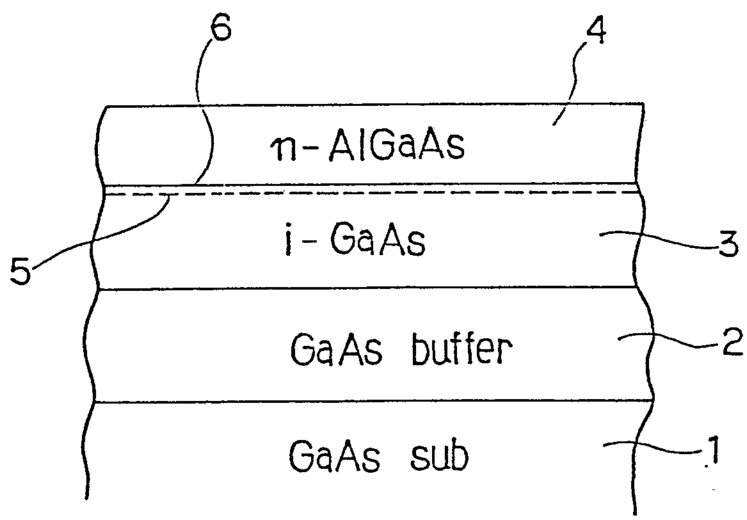
6
4
n-AlGaAs
5
i-GaAs
3
GaAs buffer
2
GaAs sub
1

Fig. 3

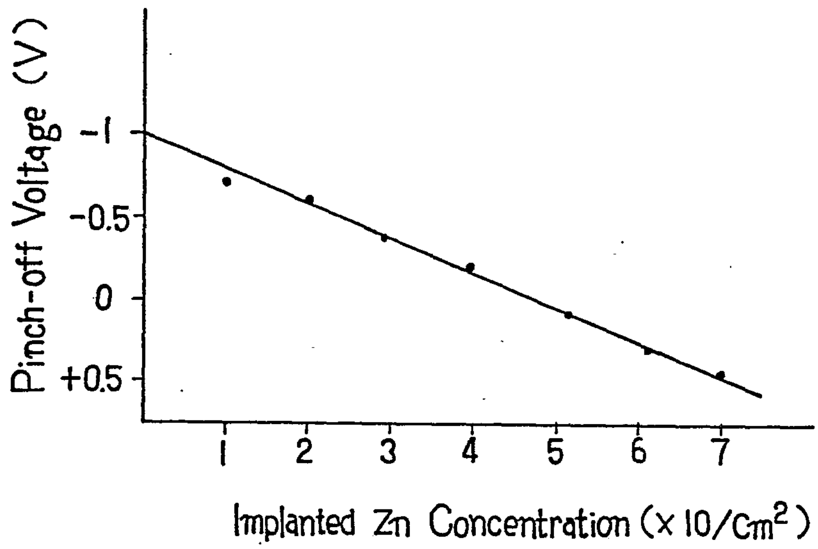
Pinch-off Voltage (V)
-1
-0.5
0
+0.5
1
2
3
4
5
6
7
Implanted Zn Concentration (×10/Cm²)

Fig. 4

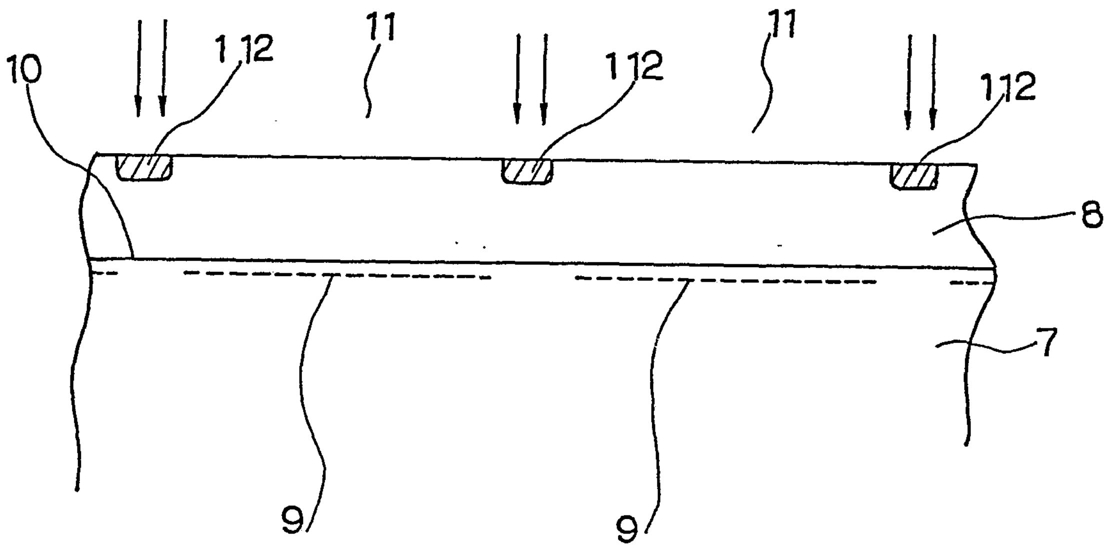
10
112
11
112
11
112
8
7
9
9

Fig. 5

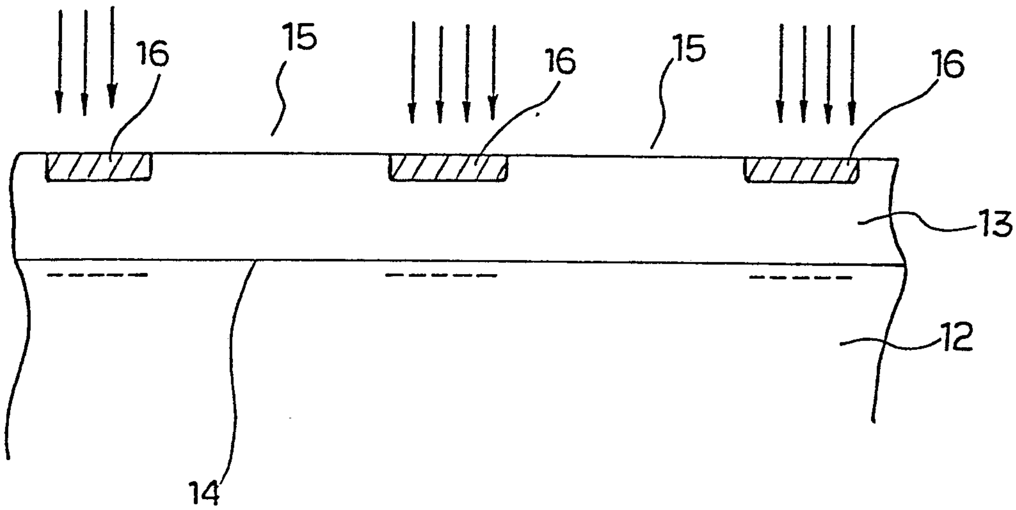


Fig. 6

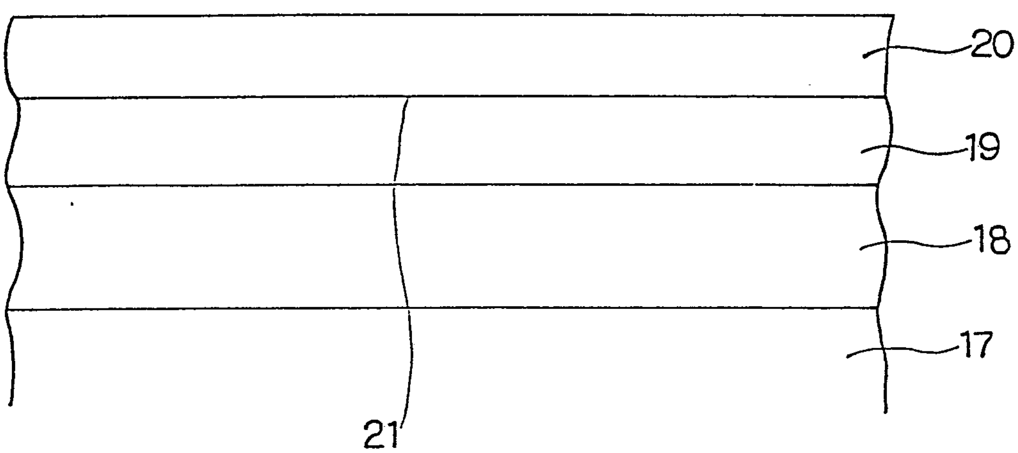

Fig. 7

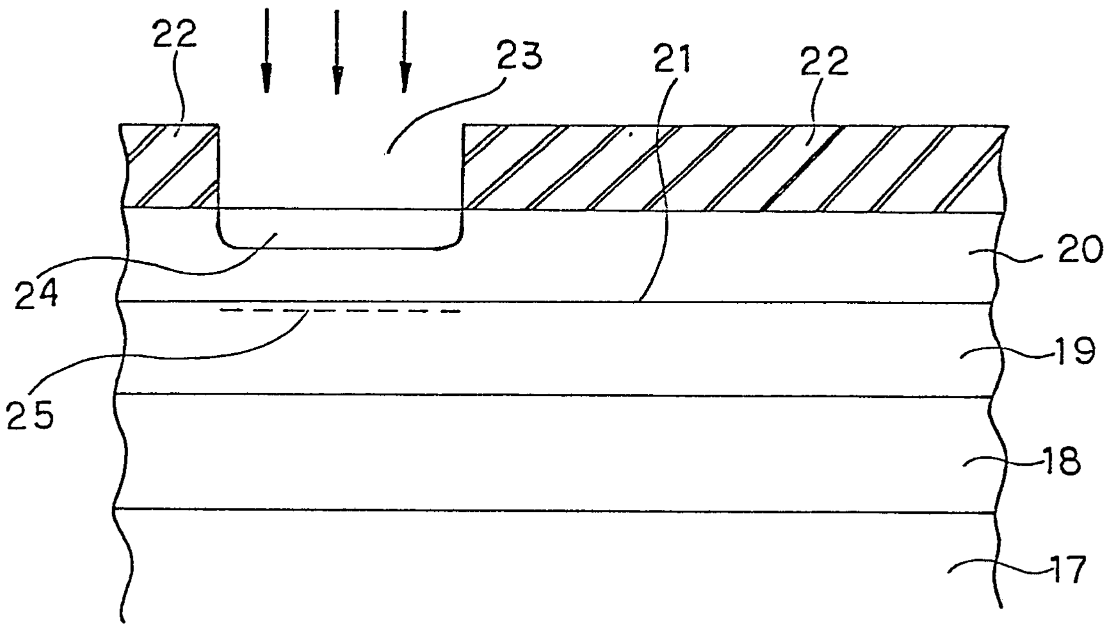
22
23
21
22
20
24
19
25
18
17

Fig. 8

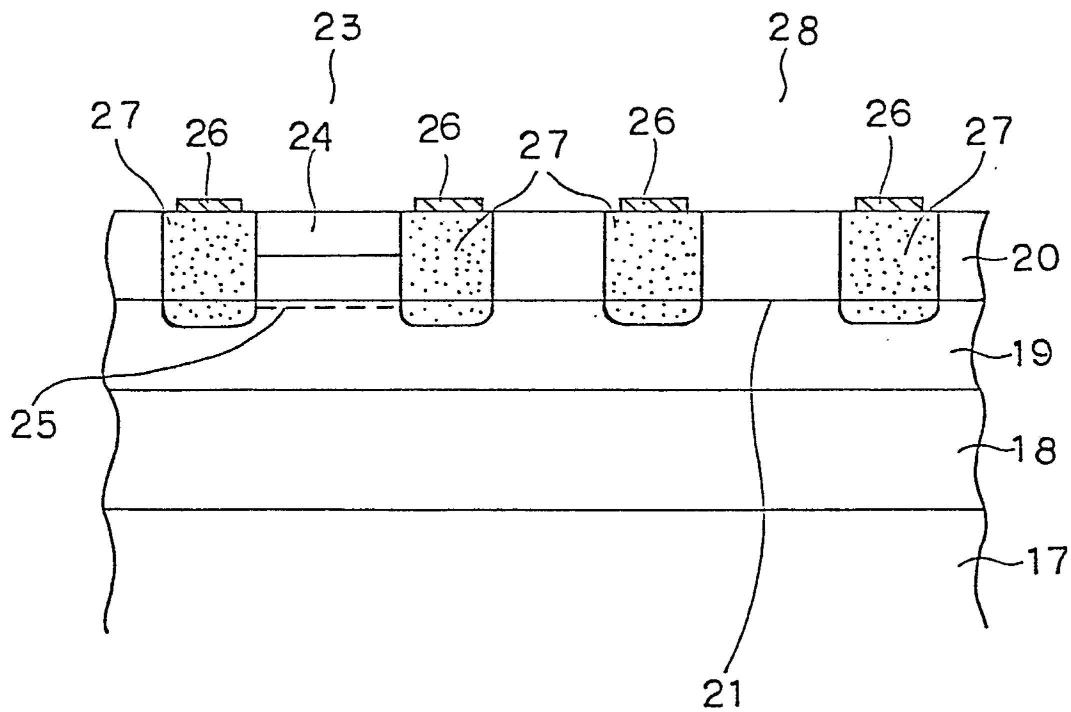
23
28
27
26
24
26
27
26
26
27
20
19
25
18
17
21

Fig. 9